(19) Europäisches Patentamt
European Patent Office
Office européen des brevets

(11) **EP 3 107 213 B1**

(12) **EUROPEAN PATENT SPECIFICATION**

(45) Date of publication and mention
of the grant of the patent:
**06.01.2021  Bulletin 2021/01**

(21) Application number: **15172783.1**

(22) Date of filing: **18.06.2015**

(51) Int Cl.:
*H03L 7/099* (2006.01)    *H03C 3/09* (2006.01)

(54) **FREQUENCY SYNTHESIZER CIRCUIT WITH LINEARIZED GAIN OF THE CONTROLLED OSCILLATOR**

FREQUENZSYNTHESIZERSCHALTUNG MIT LINEARISIERTER VERSTÄRKUNG DES GESTEURTEN OSZILLATORS

CIRCUIT SYNTHÉTISEUR DE FRÉQUENCE AVEC UN GAIN LINÉARISÉE DE L'OSCILLATEUR COMMANDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.12.2016  Bulletin 2016/51**

(73) Proprietor: **NXP B.V.**
**5656 AG Eindhoven (NL)**

(72) Inventors:
• **Saric, Tarik**
**Redhill, Surrey RH1 1SH (GB)**
• **Osorio Tamayo, Juan Felipe**
**Redhill, Surrey RH1 1SH (GB)**

(74) Representative: **Hardingham, Christopher Mark**
**NXP Semiconductors**
**Intellectual Property Group**
**Abbey House**
**25 Clarendon Road**
**Redhill, Surrey RH1 1QZ (GB)**

(56) References cited:
**US-A1- 2008 012 654     US-A1- 2008 111 642**
**US-A1- 2008 284 531     US-A1- 2009 256 643**

• **PENG CHEN ET AL: "AVCO with F-V linearization techniques for CNS application", 2013 IEEE 10TH INTERNATIONAL CONFERENCE ON ASIC, IEEE, 28 October 2013 (2013-10-28), pages 1-4, XP032594019, ISSN: 2162-7541, DOI: 10.1109/ASICON.2013.6811906 ISBN: 978-1-4673-6415-7 [retrieved on 2014-05-07]**
• **THOMAS USSMUELLER ET AL: "Phase-locked loop based frequency synthesizer with chirp generation for FMCW secondary radar systems", WIRELESS INFORMATION TECHNOLOGY AND SYSTEMS (ICWITS), 2010 IEEE INTERNATIONAL CONFERENCE ON, IEEE, PISCATAWAY, NJ, USA, 28 August 2010 (2010-08-28), pages 1-4, XP031782548, ISBN: 978-1-4244-7091-4**

## Description

The present disclosure relates to a sensor for a radar system, used for distance measurement, having a PLL frequency synthesizer generating a linear chirp signal.

In particular, the present disclosure relates to the use of varactors to compensate for variations in the open loop gain of such PLL frequency synthesizer.

Various example embodiments of systems, methods, apparatuses, devices, articles of manufacture and computer readable mediums for frequency synthesizer circuits are now discussed. Phase locked loops (known as PLLs) are control systems (frequency synthesiser circuits) used to generate output signals. A phase locked loop generates an output signal with a phase related to the phase of a highly accurate input signal (reference signal). A PLL is typically used to ensure that the clock frequencies of signal inputs of various registers and flip-flops match the frequency generated by an oscillator. Without a PLL, clock skew may result in the registers and flip-flops not receiving the clock at the same time.

Traditional analogue PLLs utilise a voltage controlled oscillator (VCO) to provide an oscillating waveform with a variable frequency. The output of the VCO is compared to a reference input signal by a phase detector, which compares the phase of the input and output signals and adjusts the oscillator to keep the phases matched. This acts as a feedback loop.

The frequency of the output may be varied by introducing a divider that allows the output frequency to be a multiplied copy of the lower reference frequency, which is usually insensitive to process voltage and temperature variations. However, this provides the constraint that the oscillator frequency is equal to an integer multiple of the reference frequency. Such analogue circuits are called integer-N frequency synthesisers.

This limitation may be overcome by introducing a modulator or dither to divide the value of the divider to achieve fractional divide values. The resulting variations are smoothed by the PLL using a loop filter. Such analogue PLL's are called fractional-N frequency synthesisers.

The gain of the phase lock loop is a design parameter that is used to optimize the bandwidth, locking time and noise performance of the PLL. For example, both the charge pump gain, $K_D$ (PFD/CP gain) and the oscillator gain, Kvco (VCO gain) are parameters that are ideally linear. This is broadly the case in traditional PLLs for the charge pump gain, but for the voltage controlled oscillator gain the gain is typically peaked due to the electrical response of the varactor used to tune the PLL.

The gain of the voltage controlled oscillator operates in this narrow window due to the peak gain response. This is in most applications acceptable since the PLL is locked to one frequency that corresponds to a mid-tune voltage. In systems where the tuned voltage is changing in time, for example to generate frequency chirp, this decrease in Kvco leads to a phase noise variation and linearity variation of this frequency chirp. This is unsuitable in some applications, such as in sensors for car radar systems. In such systems, a frequency synthesiser circuit with a more constant gain profile over the tuning voltage is desirable.

US2008111642 discloses a method of linearizing a frequency versus tuning voltage response of a voltage controlled oscillator comprising multiple varactor sets. In one example, a the method of linearizing includes acts of providing a first varactor set with a first bias voltage, providing a second varactor set with a second bias voltage, and adjusting the first and second bias voltages so as to linearize the frequency versus tuning voltage response of the voltage controlled oscillator over a selected operating frequency range of the voltage controlled oscillator. The method can be extended to N varactor sets and can be applied to many RF CMOS or analog CMOS components, including voltage controlled oscillators.

Thomas Ussmueller et al. "Phase-Locked Loop Based Frequency Synthesizer with Chirp Generation for FMCW Secondary Radar

Systems" ISBN: 978-1-4244-7091-4 discloses a synthesizer which is optimized for secondary radar systems. It is based on a fractional-N phase-locked loop. Additional circuitry is necessary to generate the frequency ramp and minimize the associated spurs. The synthesizer has been implemented in a 0.18um SiGe BiCMOS process. Measurement results showed its suitability for high performance local positioning systems.

Peng Chen et al. "A VCO with F-V Linearization Techniques for CNS application" discloses a VCO for compass navigation system (CNS) application. It has a linearized $K_{VCO}$ and is robust to varactor bias variations. A voltage limit circuit is proposed to ensure that the varactors work in the depletion region. To compensate for active loop filter's lack of driving ability, a rail to rail opamp is used. Post-simulation results show that a better Kvco performance is achieved compared to the conventional one with tuning voltage changing from 0.15V to 1.65V. Implemented in a 0.18tun CMOS process, the proposed VCO operates at 3.2 GHz with power supply of 1.8V.

## Summary

According to a first aspect of the present disclosure, there is provided a sensor for a radar system comprising a frequency synthesiser circuit, the circuit comprising: a phase locked loop comprising a voltage controlled oscillator adapted to provide a frequency chirp at a range of tuning voltages, said phase locked loop further comprising: a phase detector; a charge pump adapted to supply the tuning voltage; and wherein said phase locked loop has an open loop gain dependent on the tuning voltage and a gain of the voltage controlled oscillator; a first varactor unit for altering the gain of the voltage controlled oscillator over a first subset range of tuning voltages to compensate for a drop-off in a gain of the charge pump at low tuning voltages; and a second varactor unit for altering the gain of the voltage controlled oscillator over a second subset range of tuning voltages to compensate for a drop-off in a gain of the charge pump at high tuning voltages, wherein the second subset range of tuning voltages is higher than the first subset range of tuning voltages; such that variations in the open loop gain over the first and second subset range of voltages of the range of tuning voltages are compensated for by the varactor units and wherein the frequency chirp relates to a distance measurement.

Other aspects of the present disclosure are defined in the appended dependent claims.

The present invention is defined by the appended claims.

The above discussion is not intended to represent every example embodiment or every implementation within the scope of the appended claims.

The Figures and Detailed Description that follow also exemplify various example embodiments. Various example embodiments may be more completely understood in consideration of the following Detailed Description in connection with the accompanying Drawings.

Brief description of Drawings

Embodiments will be described, by way of example only, with reference to the drawings, in which

figure 1A shows a typical phase locked loop architecture with a voltage controlled oscillator;
figure 1B shows a typical gain for the phase frequency detector of figure 1A;
figure 1C shows a typical gain for the voltage controlled oscillator of figure 1A;
figure 2A shows a typical response of the tuning voltage supplied by the architecture of figure 1 as the frequency of the architecture of figure 1A varies over time, for different gains of the voltage controlled oscillator;
figure 2B shows the variation of the frequency of the voltage controlled oscillator over the time corresponding to figure 2A;
figure 3A shows a frequency response of varactor units over a swept tuning voltage range according to an example embodiment of the present disclosure;
figure 3B shows the derivative of the varactor units frequency response shown in figure 3A;
figure 3C shows the Charge-Pump gain across the swept tuning voltage range using the varactor units of figure 3A;
figure 3D shows the voltage controlled oscillator gain across the swept tuning voltage range using the varactor units of figure 3A;
figure 4 shows a circuit implementation with an arrangement of varactors according to an example embodiment of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

Detailed description of embodiments

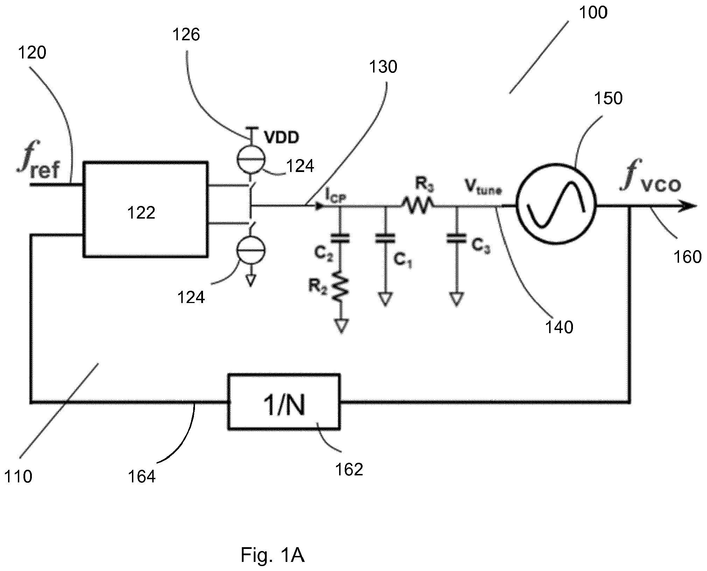

An example of a frequency synthesiser circuit, known as a Phase Locked Loop (PLL) is shown in Figure 1A. The phase locked loop 110 comprises a Phase Detector 122 that receives an incident reference frequency signal 120 and divider signal 164. Charge Pumps 124 (CPs), biased by a drive voltage 126, are provided to translate the phase difference of the reference signal 120 and the divider signal 164 into a voltage 130 that is filtered by a low pass filter arrangement 132. A tuning voltage 140 is then supplied to a voltage controlled oscillator 150 (VCO) and a voltage controlled oscillator frequency signal 160 generated. As noted above, the divider signal 164 is generated by a divider 162, which is used to control a frequency sweep or chirp of the voltage controlled oscillator frequency signal 160. The divider 162 is often implemented with a sigma-delta to obtain a fractional-N PLL.

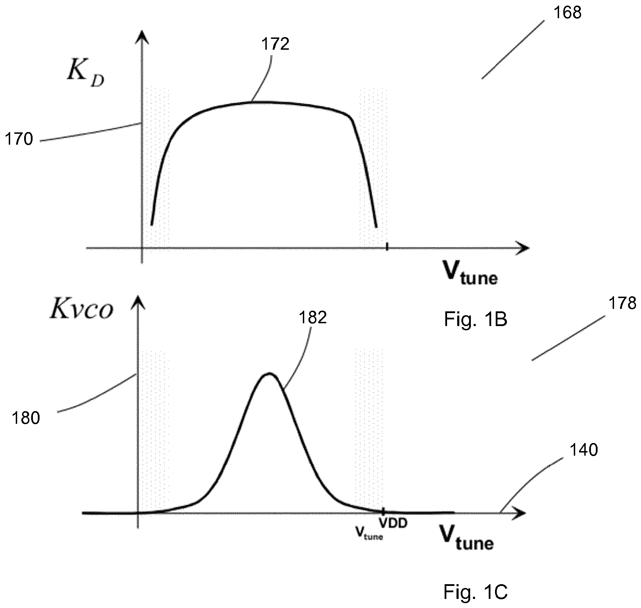

The gain of the phase lock loop 110 is a design parameter that is used to optimize the bandwidth, locking time and noise performance of the PLL. For example, both the charge pump gain, $K_D$ (PFD/CP gain) and the oscillator gain, Kvco (VCO gain) are parameters that are ideally linear. Figure 1B shows 168 a typical response 172 of the gain $K_D$ 170 as a function of the tuning voltage 140. The response 172 is broadly flat except at low and high tuning voltages.

The response 178, 182 of the gain 180 of the voltage controlled oscillator 150 as a function of the tuning voltage 140 is shown in Figure 1C. This response, is typically defined by the varactor transfer function, which in embodiments is modelled by a Hyperbolic Tangent function. Hence it is dependent upon the voltage used to tune the PLL, the $V_{tune}$ voltage resulting in a peaked derivative response as shown in 178. As shown, the gain of the voltage controlled oscillator, $K_{VCO}$, typically has a sharply peaked variation as the tuning voltage is swept from 0 to a maximum drive voltage VDD. In most applications this variation is acceptable, since calibration of the varactor is used to operate the PLL around a mid $V_{tune}$ voltage (VDD/2), which is broadly level for $K_D$ and $K_{VCO}$. The PLL subsequently locks onto this mid tuning voltage which is related to the phase and frequency of the driving signal, as well as the gain from the oscillator. If the PLL is operated outside of this sweet spot frequency errors occurs as the degraded phase noise.

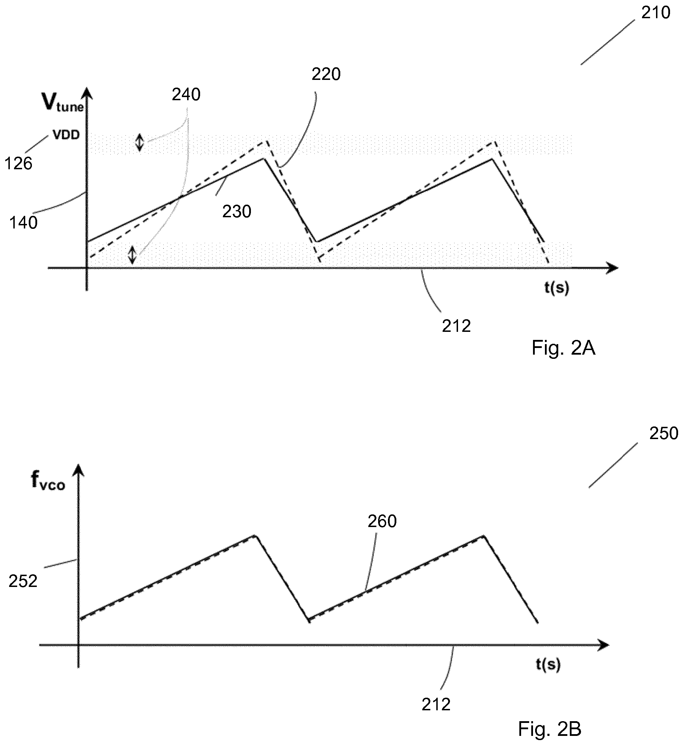

However, not all applications allow a steady input frequency or voltage. In some applications, such as car radar systems the frequency is swept and a chirp generated (by changing the division ratio) from a starting frequency by an amount dependent upon the bandwidth. Such a sweep is shown in Figure 2A 210 as a function of the tuning voltage and in Figure 2B 220 as a function of the frequency. In figure 2A, the tuning voltage 140 or varactor is swept over almost its full range of voltages (220 - dashed line in Figure 2A) over a period of time 212, minus a small chargepump/VCO headroom 240 above zero voltage and below the drive voltage 126. However, crossing these headroom boundaries 240 results in a large open loop gain variation, large variation in PLL bandwidth, high settling times and also to poor phase noise performance in the system. If the voltage is low, sources are lost and the charge pump gain drops. Accordingly, the systems are overdesigned, resulting in a higher Kvco gain and a reduced Vtune range as the tuning voltage range is swept (idealized overdesigned gain 230 - solid line in Figure 2A).

Figure 2B shows the variation 250 of the frequency 252 over the period of time 212 by varying the voltage as shown in figure 2A for the idealized overdesigned gain 230, which provides frequency response 260.

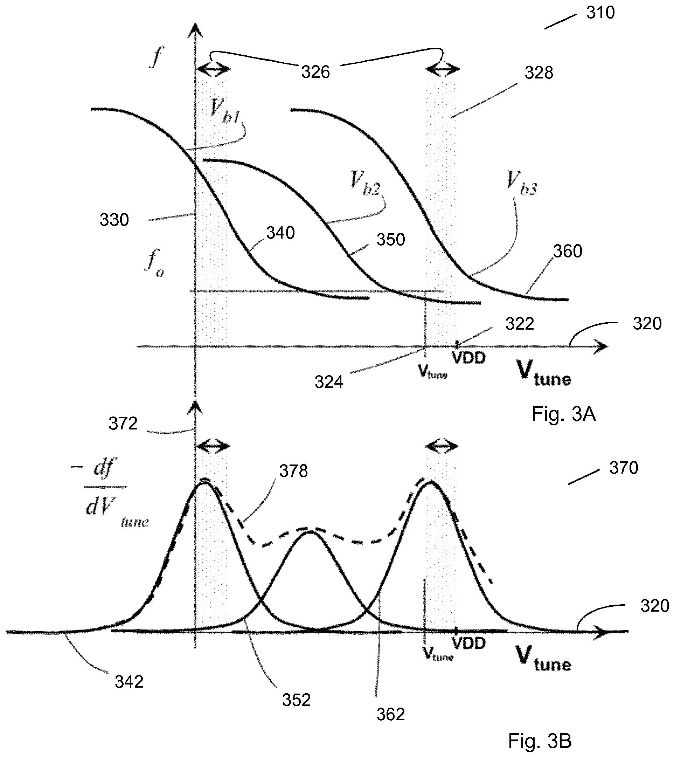

As noted above, the variation of the response of a phase locked loop is at least partially determined by the electrical configuration of components known as varactors. In the present disclosure a number of varactors are employed within a phase locked loop system. Figure 3a shows 310 how the frequency response 330 of a number of varactors 340, 350, 360 varies as the tuning voltage 320 varies or is swept in a PLL system. As shown, a drive voltage 322 is typically moderated down to a maximum tuning voltage 324. A headroom 326 due mainly to the chargepump is also present. The upper headroom 328 is generally between the ideal maximum tuning voltage 324 and the drive voltage 322.

It can be seen that the frequency response of the varactors at subset ranges of tuning voltages $V_{b1}$, $V_{b2}$, $V_{b3}$ can be chosen to provide the frequency response desired. For example, the first varactor 340 is configured to generate a varying capacitance and therefore a varying frequency response over a first subset range of tuning voltages $V_{b1}$ ranging from a negative voltage to a positive voltage broadly centred around zero volts. The second varactor 350 is configured to generate a varying capacitance and therefore a varying frequency response over a second subset range of tuning voltages $V_{b2}$ between zero volts and the tuning or drive voltage 322. Similarly the third varactor 360 is configured to generate a varying capacitance and therefore a varying frequency response over a third subset range of tuning voltages $V_{b3}$ broadly centred around the tuning voltage 324.

A derivative representation 370 of the frequency response 372 of the varactors plotted in figure 3a as the voltage 320 varies is shown in figure 3b. The first varactor, having a tuning range of $V_{b1}$, has a derivative frequency response 342 broadly centred around $V_{tune}$ = 0. The third varactor, having a tuning range of $V_{b3}$, has a derivative frequency response 362 centred broadly around the maximum tuning voltage $V_{tune}$ 324, with the second varactor, having tuning range $V_{b2}$, sitting between. The overall derivative frequency response of all three varactors is curve 378.

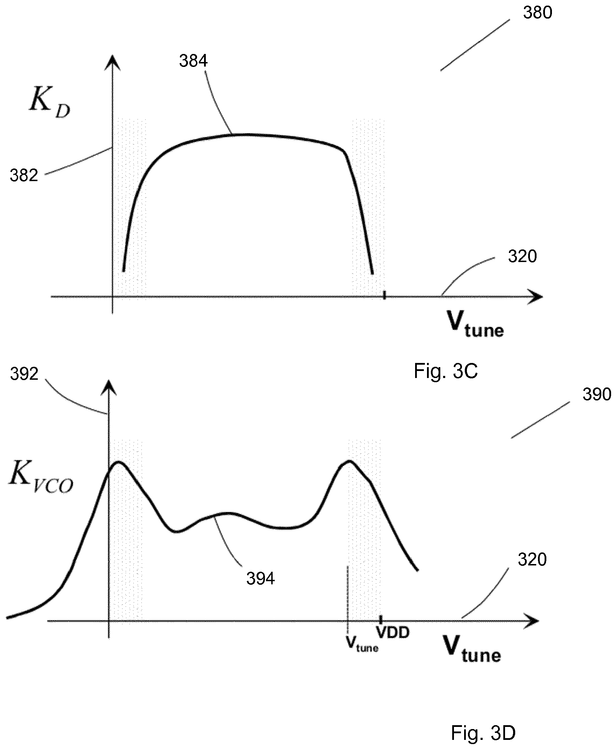

Applying the use of several varactors to a phase lock loop circuit such as shown in figure 1A allows the gain of the voltage controlled oscillator 150 to be altered to reduce the large variation at high and low tuning voltages as shown in figure 1B. Figure 3C shows 380 how the gain 382 of the phase detector $K_D$ varies as the tuning voltage 320 is altered. The response 384 is broadly flat except at high and low tuning voltages. This is similar to the gain characteristics of the phase detector of known phase locked loops as shown in figure 1B.

However, for the gain of the voltage controlled oscillator, the use of several varactors provides a greatly altered response as shown 390 in figure 3D, in comparison to figure 1C. The response 394 of the gain 392 of the voltage controlled oscillator 150 as the tuning voltage 320 is swept from 0 to a drive voltage is broadly similar to the derivative frequency response shown in figure 3b. Instead of the single peak at around half the drive voltage as shown in Figure 1C, the response 390 has a number of peaks at voltages equal to the maximum differential response of each varactor. In the example shown, three varactors are employed, the first varactor 340 has a maximum derivative frequency response at the drive voltage, the second varactor 350 has a maximum response at half the drive voltage and the third varactor has a maximum response at 0V. The combined response provides a gain response of the open loop gain of the frequency synthesiser circuit in which the varactors are used with peaks at the same respective voltages as the varactors used, however the overall response is broadly more even with less variation than the single varactor response shown in figure 1C.

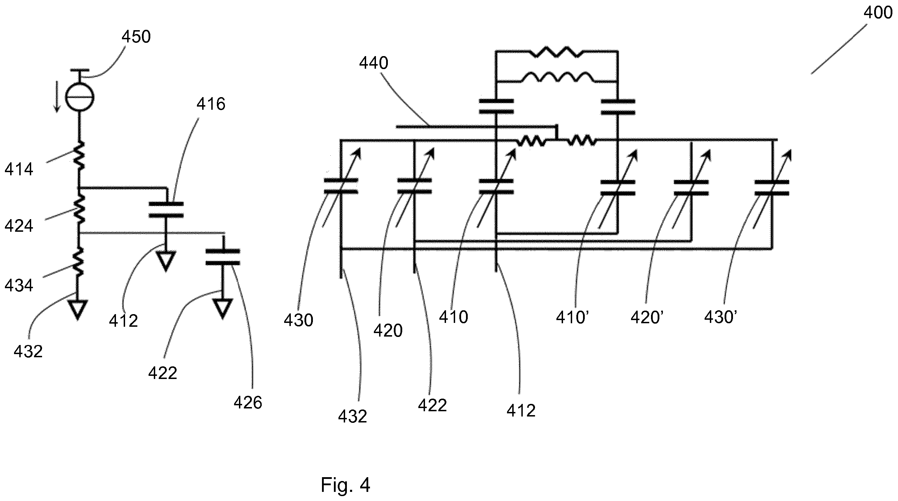

Figure 4 shows an exemplary system 400 of varactor units used with a voltage controlled oscillator of a PLL according to the present disclosure. In the present example, the voltage controlled oscillator has a first varactor unit comprising a first and second varactor 410, 410' biased by a drive or bias voltage 412. A second varactor unit is provided, which comprises a first and second varactor 420, 420' biased by a second bias voltage 422. Additionally a third pair of varactors 430, 430' are also provided to form a third varactor unit, biased by a third bias voltage 432.

A tuning voltage 440 is supplied to the voltage controlled oscillator, driven by the charge pump 124, which produces a frequency response of the voltage controlled oscillator dependent on the bias of the voltage controlled oscillator and the value of the tuning voltage (as shown in Figure 2A).

The gain of the voltage controlled oscillator is determined by the varactor units and the inherent gain of the voltage controlled oscillator. Accordingly, by altering the characteristics and/or number of varactor units and/or the bias voltages supplied to the varactor units, the gain of the voltage controlled oscillator can be controlled.

Consequently, the varactor units within the voltage controlled oscillator act to alter the gain of the voltage controlled oscillator, which in turn alters the frequency response of the voltage controlled oscillator with respect to the range of tuning voltages supplied to the voltage controlled oscillator as shown in Figure 2A. It is therefore possible to smooth out variations in the overall open-loop gain of the PLL and therefore in the frequency response of the voltage controlled oscillator at different applied tuning voltages.

In particular, the varactor units are scaled or sized to alter the voltage controlled oscillator gain that is higher at low and high tuning voltages to compensate for drop-off in the gain of the charge pump. This allows the overall open loop gain of the phase locked loop to remain substantially constant. In other words, by providing a non-linear bias of the voltage controlled oscillator by choosing the number and/or characteristics of the varactors within the voltage controlled oscillator, a linear open loop gain of the phase locked loop can be achieved.

It can be appreciated that more of less varactor units may be employed within the voltage controlled oscillator depending upon the required application. Additionally, although shown as pairs of varactors, each varactor unit may be a single varactor biased by a single bias voltage, a triplet of varactors each biased by a single bias voltage, or 4 or more varactors each biased by a single bias voltage.

Each varactor 410, 420, 430 (and corresponding pair) in the example shown comprises a capacitor. However diodes or other electrical components that have a gain response that varies with frequency may be used as varactors.

The bias voltages are provided from a current source 450 in series with a resistor 414: and in parallel with a capacitor 416 for the first bias voltage 412; in series with a second resistor 424 and in parallel with a second capacitor 426 for the second bias voltage 422; and in series with the second 424 and a third resistor 434 for the third bias voltage 432.

The total capacitance of each varactor shown in figure 4 is given by:

$$C_{var} = C_{var,min} + C_a \cdot \tanh\left(\frac{Vg - V_{s/d}}{V_{nom}}\right);$$

where $C_{var}$ is the total capacitance of the varactor; $C_{var,min}$ is the natural capacitance of the varactor electrical components; $C_a$ is the portion of the varactor capacitance dependent upon voltage, which is dependent on the tanh function; $V_g$ is the current gain voltage supplied to the varactor by current that flows into a resistor, which is normally constant; $V_{s/d}$ is the tuning voltage applied to

the PLL; and $V_{nom}$ is the nominal voltage of the varactor, typically determined by the process or system use.

It can be appreciated that $V_g$ and $V_{s/d}$ can be swapped, resulting in an inverse graph to that shown in Figure 3b. Consequently, if $V_g$ is used as a tuning voltage and $V_{s/d}$ is constant, then the slope of the transfer function of the varactor is positive, whilst its frequency response and slope is negative (the frequency is roughly proportional to the inverse square root of the capacitance of the varactor

Tuning of the varactor units is possible by adding further varactors, altering the varactor components or by altering the bias voltage characteristics. Although shown as three pairs of varactors, any number such as 10 or more pairs may be used, however phase noise considerations provide a notable trade off as the total number of varactors increases.

The phase locked loop 100 comprising the varactors 400 described above may be used to generate a frequency chirp for applications such as sensors. One example may be a sensor for radar systems suitable for use within a car radar system. In such applications, as the tuning voltage is swept, the frequency output of the PLL varies due to the variance in the open loop gain (due to the variance in the voltage controlled oscillator gain caused by the varactors 410, 420, 430).

From reading the present disclosure, other variations and modifications will be apparent to the skilled person. Such variations and modifications may involve equivalent and other features which are already known in the art of varactors and which may be used instead of, or in addition to, features already described herein.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A sensor for a radar system comprising a frequency synthesiser circuit, the circuit comprising:

   a phase locked loop (110) comprising a voltage controlled oscillator adapted to provide a frequency chirp at a range of tuning voltages, said phase locked loop (110) further comprising:

   a phase detector (122);
   a charge pump (124) adapted to supply the tuning voltage; and
   wherein said phase locked loop has an open loop gain dependent on the tuning voltage and a gain of the voltage controlled oscillator

**characterized by** a first varactor unit (340) for altering the gain of the voltage controlled oscillator over a first subset range of tuning voltages to compensate for a drop-off in a gain of the charge pump at low tuning voltages; and

a second varactor unit (350) for altering the gain of the voltage controlled oscillator over a second subset range of tuning voltages to compensate for a drop-off in a gain of the charge pump at high tuning voltages, wherein the second subset range of tuning voltages is higher than the first subset range of tuning voltages; such that variations in the open loop gain over the first and second subset range of voltages of the range of tuning voltages are compensated for by the varactor units and wherein the frequency chirp relates to a distance measurement.

2. The sensor of claim 1, wherein the first and second varactor units (340, 350) alter the gain of the voltage controlled oscillator relative to the gain of the charge pump (124) such that the open loop gain is substantially constant.

3. The sensor of claim 1 or claim 2, further comprising a third varactor unit (360) for altering the gain of the voltage controlled oscillator (150) over a third subset range of tuning voltages, wherein the third subset range of tuning voltages is lower than the second subset range of tuning voltages and higher than the first subset range of tuning voltages.

4. The sensor of claim 3, wherein the third varactor (360) alters the gain of the voltage controlled oscillator (150) less than the first or second varactor (340, 350).

5. The sensor of any preceding claim, further comprising an nth varactor unit for altering the gain of the voltage controlled oscillator over an nth subset range of tuning voltages of the range of tuning voltages.

6. The sensor of any preceding claim, wherein each varactor unit comprises a pair of varactors biased by a bias voltage (412, 422, 432).

7. The sensor of claim 6, wherein the bias voltage is generated by a current and a low pass filter.

8. The sensor of claim 6 or claim 7, wherein the amount of compensation in the open loop gain by the varactor units (340, 350, 360) is dependent upon the capacitance of the varactor unit and the bias voltage of the varactor unit.

9. The sensor of any preceding claim, wherein the varactor units (340, 350, 360) compensate for variations in the open loop gain at high and low sweeping tune voltages.

10. The sensor of any preceding claim, wherein the varactor units (340, 350, 360) contain diodes.

11. The sensor of any preceding claim, wherein the varactor units (340, 350, 360) contain capacitors.

12. The sensor of any preceding claim, wherein a divider (162) is provided and implemented with a sigma-delta to obtain a fractional-N phase locked loop.

13. The sensor of any preceding claim, wherein the frequency chirp of the phase locked loop is generated by changing a division ratio of a divider (162) and/or by changing a reference frequency signal.

**Patentansprüche**

1. Sensor für ein Radarsystem, das eine Frequenzsynthesizerschaltung umfasst, wobei die Schaltung umfasst:

einen Phasenregelkreis (110), der einen spannungsgesteuerten Oszillator umfasst, der ausgelegt ist, einen Frequenzchirp in einem Bereich von Abstimmspannungen bereitzustellen, wobei der Phasenregelkreis (110) ferner umfasst:

einen Phasendetektor (122); eine Ladungspumpe (124), die ausgelegt ist, die Abstimmspannung zu liefern; und wobei der Phasenregelkreis eine Leerlaufverstärkung aufweist, die abhängig von der Abstimmspannung und einer Verstärkung des spannungsgesteuerten Oszillators ist **gekennzeichnet durch** eine erste Varaktoreinheit (340) zum Ändern der Verstärkung des spannungsgesteuerten Oszillators über einen ersten Teilmengenbereich von Abstimmspannungen, um einen Abfall bei einer Verstärkung der Ladungspumpe bei niedrigen Abstimmspannungen zu kompensieren; und

eine zweite Varaktoreinheit (350) zum Ändern der Verstärkung des spannungsgesteuerten Oszillators über einen zweiten Teilmengenbereich von Abstimmspannungen, um einen Abfall bei einer Verstärkung der Ladungspumpe bei hohen Abstimmspannungen zu kompensieren, wobei der zweite Teilmengenbereich von Abstimmspannungen höher als der erste Teilmengenbereich von Abstimmspannungen ist; so dass Schwankungen bei der Leerlaufverstärkung über den ersten und zweiten Teilmengenbereich von Spannungen des Bereichs von Abstimmspannungen durch die Varaktoreinheiten kompensiert werden und wobei sich der Frequenzchirp auf eine Distanzmessung bezieht.

2. Sensor nach Anspruch 1, wobei die ersten und zweiten Varaktoreinheiten (340, 350) die Verstärkung des spannungsgesteuerten Oszillators relativ zu der Verstärkung der Ladungspumpe (124) derart ändern, dass die Leerlaufverstärkung im Wesentlichen konstant ist.

3. Sensor nach Anspruch 1 oder Anspruch 2, ferner umfassend eine dritte Varaktoreinheit (360) zum Ändern der Verstärkung des spannungsgesteuerten Oszillators (150) über einen dritten Teilmengenbereich von Abstimmspannungen, wobei der dritte Teilmengenbereich von Abstimmspannungen niedriger als der zweite Teilmengenbereich von Abstimmspannungen und höher als der erste Teilmengenbereich von Abstimmspannungen ist.

4. Sensor nach Anspruch 3, wobei der dritte Varaktor (360) die Verstärkung des spannungsgesteuerten Oszillators (150) weniger ändert als der erste oder zweite Varaktor (340, 350).

5. Sensor nach einem der vorhergehenden Ansprüche, ferner umfassend eine n-te Varaktoreinheit zum Ändern der Verstärkung des spannungsgesteuerten Oszillators über einen n-ten Teilmengenbereich von Abstimmspannungen des Bereichs von Abstimmspannungen.

6. Sensor nach einem der vorhergehenden Ansprüche, wobei jede Varaktoreinheit ein Paar von Varaktoren umfasst, die durch eine Vorspannung (412, 422, 432) vorgespannt sind.

7. Sensor nach Anspruch 6, wobei die Vorspannung durch einen Strom und einen Tiefpassfilter erzeugt wird.

8. Sensor nach Anspruch 6 oder Anspruch 7, wobei der Betrag einer Kompensation bei der Leerlaufverstärkung durch die Varaktoreinheiten (340, 350, 360) von der Kapazität der Varaktoreinheit und der Vorspannung der Varaktoreinheit abhängt.

9. Sensor nach einem der vorhergehenden Ansprüche, wobei die Varaktoreinheiten (340, 350, 360) Schwankungen bei der Leerlaufverstärkung bei hohen und niedrigen Wobbelabstimmspannungen kompensieren.

10. Sensor nach einem der vorhergehenden Ansprüche, wobei die Varaktoreinheiten (340, 350, 360) Dioden enthalten.

11. Sensor nach einem der vorhergehenden Ansprüche, wobei die Varaktoreinheiten (340, 350, 360) Kondensatoren enthalten.

12. Sensor nach einem der vorhergehenden Ansprüche, wobei ein Teiler (162) bereitgestellt und mit einem Sigma-Delta implementiert ist, um einen Fraktional-N- Phasenregelkreis zu erhalten.

13. Sensor nach einem der vorhergehenden Ansprüche, wobei der Frequenzchirp des Phasenregelkreises durch Ändern eines Teilungsverhältnisses eines Teilers (162) und/oder durch Ändern eines Referenzfrequenzsignals erzeugt wird.

## Revendications

1. Capteur pour système radar comprenant un circuit synthétiseur de fréquence, le circuit comprenant :

une boucle à verrouillage de phase (110) comprenant un oscillateur commandé par tension adapté pour fournir une fluctuation de fréquence au niveau d'une plage de tensions d'accord, ladite boucle à verrouillage de phase (110) comprenant en outre :

un détecteur de phase (122) ;
une pompe de charge (124) adaptée pour fournir la tension d'accord ; et
dans lequel ladite boucle à verrouillage de phase comporte un gain en boucle ouverte dépendant de la tension d'accord et un gain de l'oscillateur commandé par tension **caractérisé par** :

une première unité de varacteur (340) pour modifier le gain de l'oscillateur commandé par tension sur une première plage de sous-ensembles de tensions d'accord pour compenser une chute dans un gain de la pompe de charge à des tensions d'accord faibles ;
et
une deuxième unité de varacteur (350) pour modifier le gain de l'oscillateur commandé par tension sur une deuxième plage de sous-ensembles de tensions d'accord pour compenser une chute dans un gain de la pompe de charge à des tensions d'accord élevées, dans lequel la deuxième plage de sous-ensembles de tensions d'accord est supérieure à la première plage de sous-ensembles de tensions d'accord ;
de sorte que des variations dans le gain en boucle ouverte sur la première et la deuxième plage de sous-ensembles de tensions de la plage de tensions d'accord sont compensées par les unités de varacteur et dans lequel la fluctuation de fréquence concerne une mesure de distance.

**2.** Capteur selon la revendication 1, dans lequel les première et deuxième unités de varacteur (340, 350) modifient le gain de l'oscillateur commandé par tension par rapport au gain de la pompe de charge (124) de sorte que le gain en boucle ouverte est quasiment constant.

**3.** Capteur selon la revendication 1 ou la revendication 2, comprenant en outre une troisième unité de varacteur (360) pour modifier le gain de l'oscillateur commandé par tension (150) sur une troisième plage de sous-ensembles de tensions d'accord, dans lequel la troisième plage de sous-ensembles de tensions d'accord est inférieure à la seconde plage de sous-ensembles de tensions d'accord et supérieure à la première plage de sous-ensembles de tensions d'accord.

**4.** Capteur selon la revendication 3, dans lequel le troisième varacteur (360) modifie le gain de l'oscillateur commandé par tension (150) moins que le premier ou le second varacteur (340, 350).

**5.** Capteur selon l'une quelconque des revendications précédentes, comprenant en outre une $n^e$ unité de varacteur pour modifier le gain de l'oscillateur commandé par tension sur une $n^e$ plage de sous-ensembles de tensions d'accord de la plage de tensions d'accord.

**6.** Capteur selon l'une quelconque des revendications précédentes, dans lequel chaque unité de varacteur comprend une paire de varacteurs polarisés par une tension de polarisation (412, 422, 432).

**7.** Capteur selon la revendication 6, dans lequel la tension de polarisation est générée par un courant et un filtre passe-bas.

**8.** Capteur selon la revendication 6 ou la revendication 7, dans lequel la quantité de compensation dans le gain en boucle ouverte par les unités de varacteur (340, 350, 360) dépend de la capacitance de l'unité de varacteur et de la tension de polarisation de l'unité de varacteur.

**9.** Capteur selon l'une quelconque des revendications précédentes, dans lequel les unités de varacteur (340, 350, 360) compensent des variations dans le gain en boucle ouverte à des tensions d'accord de balayage faibles et élevées.

**10.** Capteur selon l'une quelconque des revendications précédentes, dans lequel les unités de varacteur (340, 350, 360) contiennent des diodes.

**11.** Capteur selon l'une quelconque des revendications précédentes, dans lequel les unités de varacteur (340, 350, 360) contiennent des condensateurs.

**12.** Capteur selon l'une quelconque des revendications précédentes, dans lequel un diviseur (162) est prévu et mis en œuvre avec un sigma-delta pour obtenir une boucle à verrouillage de phase fractionnaire N.

**13.** Capteur selon l'une quelconque des revendications précédentes, dans lequel la fluctuation de fréquence de la boucle à verrouillage de phase est générée en modifiant un rapport de division d'un diviseur (162) et/ou en modifiant un signal de fréquence de référence.

100

120 — $f_{ref}$

122

126 — VDD

124

124

130 — $I_{CP}$

$C_2$

$R_2$

$C_1$

$R_3$

$C_3$

140 — $V_{tune}$

150

$f_{VCO}$ — 160

1/N — 162

164

110

Fig. 1A

Fig. 1B

Fig. 1C

210

220

240

Vtune

VDD

126

140

230

212

t(s)

Fig. 2A

250

fvco

260

252

212

t(s)

Fig. 2B

Fig. 3A

Fig. 3B

380

384

$K_D$

382

320

$V_{tune}$

Fig. 3C

392

390

$K_{VCO}$

394

320

$V_{tune}$ VDD

$V_{tune}$

Fig. 3D

Fig. 4

EP 3 107 213 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008111642 A

**Non-patent literature cited in the description**

- **THOMAS USSMUELLER.** *PHASE-LOCKED LOOP BASED FREQUENCY SYNTHESIZER WITH CHIRP GENERATION FOR FMCW SECONDARY RADAR SYSTEMS,* ISBN 978-1-4244-7091-4

- **PENG CHEN et al.** *A VCO with F-V Linearization Techniques for CNS application*